# EUROPEAN PATENT SPECIFICATION

(11) **EP 4 607 208 B1**
(45) Date of publication and mention of the grant of the patent: **04.02.2026**
(21) Application number: 24159793.9
(22) Date of filing: 26.02.2024
(51) Int. Cl.: G01R 15/18, H01F 27/30, H02B 1/20

(54) **ROGOWSKI CURRENT TRANSDUCER FOR BUSBAR ASSEMBLIES**
ROGOWSKI-STROMWANDLER FÜR SAMMELSCHIENENANORDNUNGEN
TRANSDUCTEUR DE COURANT DE ROGOWSKI POUR ENSEMBLES BARRES OMNIBUS

(43) Date of publication of application: 27.08.2025
(73) Proprietor: LEM International SA, 1217 Meyrin (CH)
(72) Inventor: CLAEYS, Stéphane, 74520 CHEVRIER (FR); TEPPAN, Wolfram, 3184 Wünnewil (CH)
(74) Representative: reuteler & cie SA

(56) References cited:
- DE-U1- 202014 103 953
- KR-B1- 102 213 783
- US-A1- 2010 156 393
- US-A1- 2024 027 500

## Description

The present invention relates to a Rogowski current transducer arrangement for busbar conductors.

Electrical current conducting arrangements for carrying large currents may include a plurality of busbar conductors in a stacked arrangement. In order to measure the current flowing in the stack of busbar conductors, it is known to provide a Rogowski cable transducer that is mounted around the stack of busbars and secured to the busbars with a holder, for instance as described in EP2990808B1 and US20230213558A1. Such holders are typically used for short Rogowski coils and are not convenient for larger busbars and busbar assemblies whereby standard rectangular cross-sections for such busbars can start at 30 mm x 5 mm and reach for instance 100 mm x 10 mm or more. For high currents that are typically up to more than 6000 A, multiple busbars are stacked. In certain applications, there is also a need to measure the current in a multiphase system with a plurality of busbar arrangements, for instance in a three-phase system there are 3 busbar stacks that may be arranged next to each other. Conventional Rogowski cable type transducers are typically not well adapted for multiphase arrangements.

Further relevant prior art is disclosed in US 2010/156393 A1.

In view of the foregoing, it is an object of this invention to provide a Rogowski current transducer arrangement for busbars, in particular for stacked busbars, that is easy to install and economical to produce and assemble.

It is advantageous to provide a Rogowski cable current transducer arrangement that is compact.

It is advantageous to provide a Rogowski cable current transducer arrangement for busbar stacks that is well adapted for multi conductor systems, in particular multiphase conductor systems.

It is advantageous to provide a Rogowski cable current transducer arrangement that allows accurate and stable positioning around a busbar stack.

Objects of this invention have been achieved by providing a Rogowski cable current transducer arrangement according to claim 1. Dependent claims set forth various advantageous features of embodiments of the invention.

Disclosed herein is a Rogowski current transducer arrangement for a busbar stack comprising a one or more stacked busbar conductors, the busbar stack having opposed top and bottom major sides, each busbar extending between opposed minor side edges. The Rogowski current transducer arrangement comprises a Rogowski cable and a Rogowski cable holder configured to support and hold the Rogowski cable (3) around the busbar stack. The Rogowski cable holder comprises a Rogowski cable support having a base wall and a cable holder channel, the base wall mountable along said outer side edges of the busbars of the busbar stack. The Rogowski cable holder further comprises anchor pieces mountable at corners of the busbar stack, and one or more fixing straps having fasteners for coupling to fasteners on the anchor pieces, the base wall of the Rogowski cable support comprising fixing rails and the anchor piece comprising complementary rails configured for coupling the Rogowski cable support to the anchor piece and fixing straps for securing the Rogowski cable around the busbar stack.

In an advantageous embodiment, the cable holder channel of the Rogowski cable support is configured to hold at least two Rogowski cables.

In an advantageous embodiment, the cable holder channel comprises a first cable holder channel and a second cable holder channel connected to a center wall section, each of the first and second cable holder channels comprising an opening with tapered entry edges configured for insertion and clipping of a section of the Rogowski cable within the cable holder channel.

In an advantageous embodiment, the fixing strap is made of an elastomeric material.

In an advantageous embodiment, the fixing strap is in the form of a band with holes therein serving as the fasteners.

In an advantageous embodiment, the anchor pieces each comprise an edge extension for engaging a side edge of the busbar stack and an overlay extension orthogonal thereto for engaging a top or bottom surface of the busbar stack.

In an advantageous embodiment, the fastener is in the form of a stud upstanding from the overlay extension.

In an advantageous embodiment, the fixing rail of the Rogowski cable support and fixing rail of the anchor pieces slidably engage each other to allow adjustment of the position of the anchor pieces along the Rogowski cable support .

Also disclosed herein is a Rogowski current transducer system for a multi-conductor system comprising at least three busbar stacks arranged in parallel side-by side, comprising at least two Rogowski current transducer arrangements according to any preceding embodiment and at least one additional Rogowski cable coupled to adjacent Rogowski cable holders of the at least two Rogowski current transducer arrangements.

In an advantageous embodiment, the Rogowski current transducer system is for a three phase conductor system comprising three busbar stacks arranged in parallel side-by side, comprising two Rogowski current transducer arrangements and one additional Rogowski cable arranged between the two Rogowski current transducer arrangements and coupled to adjacent Rogowski cable holders of the two Rogowski current transducer arrangements.

Further objects and advantageous features of the invention will be apparent from the claims, and from the detailed description, and annexed drawings, in which:
Figure 1a is a perspective view of a Rogowski cable current transducer arrangement around a stack of busbars (shown in transparency) according to an embodiment of the invention;
Figure 1b is a cross-sectional view through line Ib-Ib of figure 1a;
Figure 1c is a perspective view of a Rogowski cable holder of the embodiment of figure 1a;
Figure 1d is a side view of the holder of figure 1c;
Figure 1e is a top view of the holder of figure 1c;
Figure 2a is a perspective view similar to figure 1a of variant according to an embodiment of the invention;
Figure 2b is a cross-sectional view through lines IIb-IIb of figure 2a;
Figure 2c is a perspective view with some portions in partial transparency, of a holder of the embodiment of figure 2a;
Figure 2d is a side view of the holder of figure 2c;
Figure 2e is a top view of the holder of figure 2c;
Figure 3 is a perspective view of Rogowski cable current transducer arrangement for a three-phase busbar stack arrangement according to an embodiment of the invention;
Figure 4 is a perspective view of a Rogowski cable current transducer arrangement mounted around a busbar stack according to another embodiment of the invention.

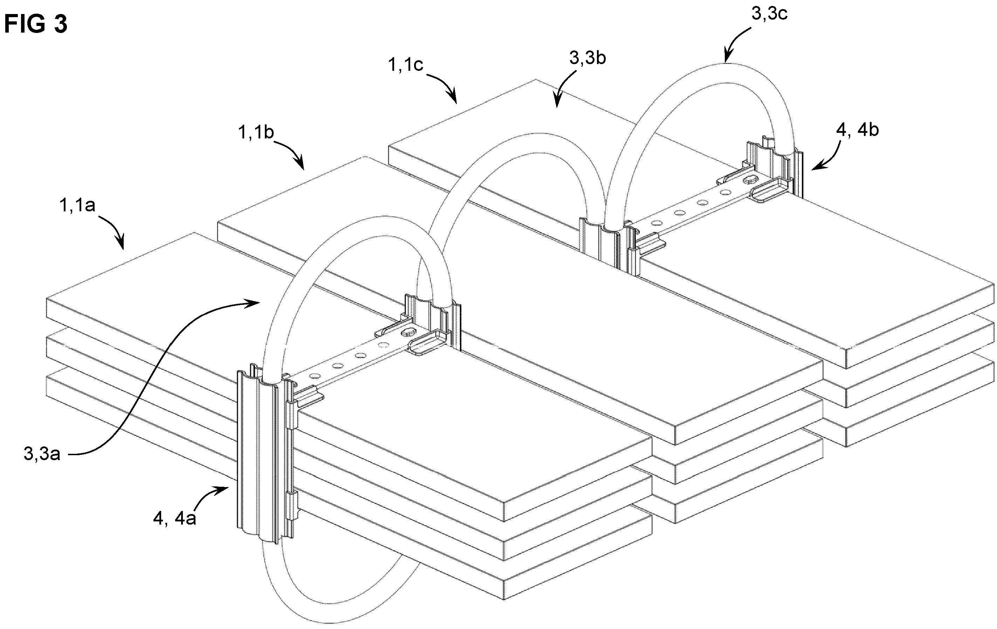

Referring to the figures, a primary conductor carrying a current to be measured may comprise a stack of busbars 1 (hereinafter referred to as a busbar stack), the number of busbars and the total cross-section of the busbars depending on the specified maximum current that may flow in the primary conductor. The primary conductor may be part of a single phase, or a multiphase electrical conductor system, for instance a three-phase electrical conductor system as illustrated in figure 3 where each of the busbar stacks 1a, 1b, 1c corresponds to an electrical phase of the electrical conductor system.

The Rogowski current transducer arrangement 2 according to an aspect of the invention comprises a Rogowski cable 3 and a Rogowski cable holder 4 configured to hold the Rogowski cable 3 around a busbar stack 1.

A Rogowski current transducer arrangement 2 may be mounted around the busbar stack 1 whereby in a multiphase arrangement such as illustrated in figure 3 a plurality of Rogowski current transducer arrangements may be mounted such that there is one Rogowski cable 3 mounted around each busbar stack 1a, 1b, 1c of an electrical phase. There may also be a plurality of Rogowski cables 3 for each phase, for instance for different measuring ranges.

Further, a larger current transducer which may be used to detect a leakage current or zero-sequence current may be present. Such a transducer can be held in the outermost cable holder channels shown empty in fig. 3.

The Rogowski cable 3 comprises a Rogowski cable section 10 that may be wrapped around one busbar stack 1 and connected together at a connection section 11, the connection section further connected to an electrical cable 12 that supplies the measurement signal output by the Rogowski cable 3 to an external circuit (not shown). The design and configuration of a Rogowski cable with a connector and an electrical cable is *per se* known and does not need to be further described herein.

An example of Rogowski cable that may be implemented in the present invention is for instance disclosed in WO2009/001185A1 or WO2021/032661.

The Rogowski cable holder 4 comprises a Rogowski cable support 5, a fixing strap 8, and an anchor piece 7 for coupling the Rogowski cable support 5 to the fixing strap 8.

The Rogowski cable support 5 comprises a cable holder channel 6 bounded on one side by a base wall 17 that is configured to be mounted against side edges 18 of the busbar stack 1 when the Rogowski cable holder 4 is mounted to the busbar stack. The base wall 17 comprises a fixing rail 9a and the anchor piece 7 comprises a complementary rail 9b that clips onto or slidably engages the fixing rail 9a.

The Rogowski cable support 5 may be in the form of an extruded plastic part with a continuous prismatic profile, cut to the required length for the busbar stack 1, or may be in a form of an injection moulded plastic part, preferably also with a continuous prismatic shape that may be cut to the required length for the busbar stack 1.

The fixing rail 9a on the base wall 17 may for instance be in the form of outer edges of the base wall 17 forming a rail 9a along which a complementary rail 9b with a complementary groove can slidably engage or clip around.

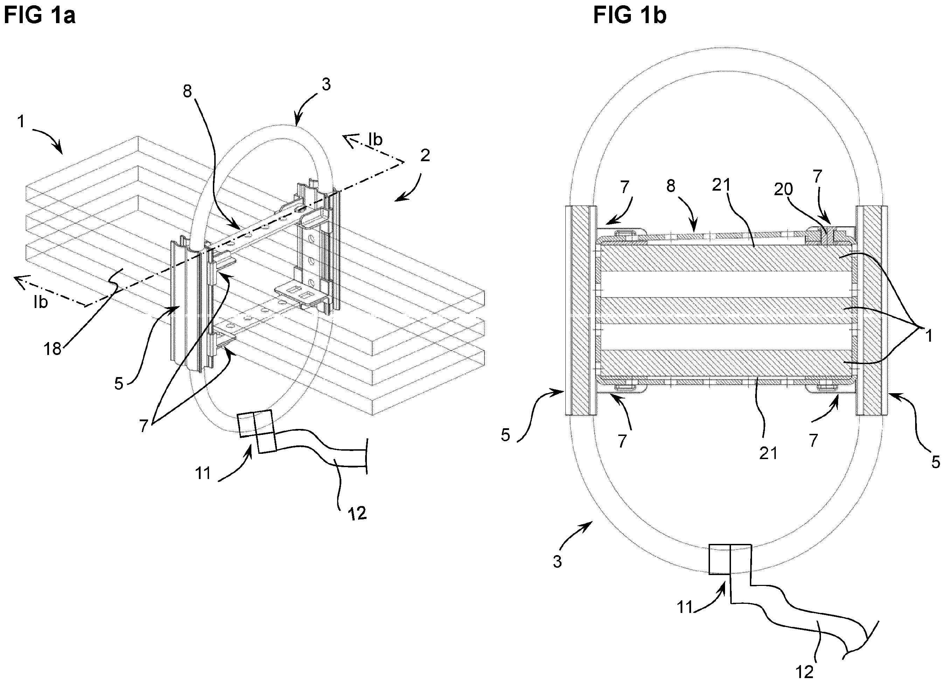

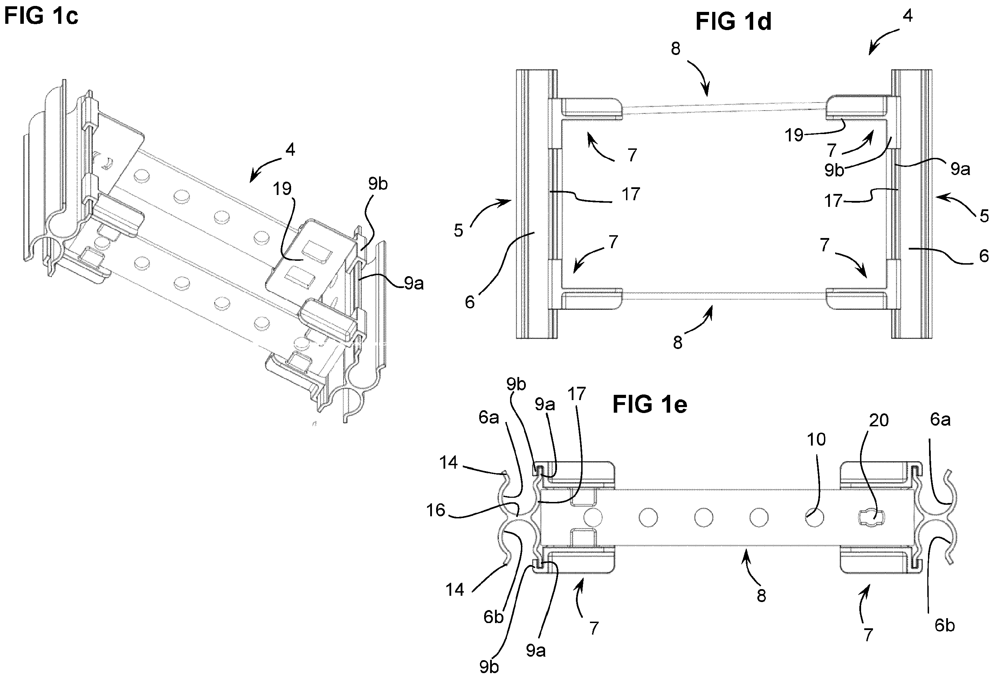

The anchor piece 7 in the embodiments of figures 1a to 3 may be configured to mount against a corner of the busbar stack such that there may be provided four anchor pieces 7, one at each of the corners of the busbar stack 1. The anchor piece 7 comprises on the one hand a complementary rail 9b that engages the fixing rail 9a of the cable holder channel base wall 17, and a busbar overlay portion 19 including a fastener 20, the overlay portion configured to lay against a major outer surface 21 of the top and bottom busbars in the busbar stack 1. The fixing strap 8 may be fixed via a complementary fastener 10 to the fastener 20 on the anchor piece 7 extending across from one outer edge 18 to the other opposite outer edge 18 of the busbar stack. In the illustrated embodiment, the fasteners comprise a stud 20 on the anchor piece 7 and a complementary hole 10 on the fixing strap 8, although other fastener arrangements may be provided, for instance a stud on the fixing strap and complementary hole or clasp on the anchor piece. Various other fastening means such as a clip that engages the anchor piece and clamps the fixing strap to the anchor piece could also be provided within the scope of the invention. Mechanical fixings such as screws or bolts that couple to the anchor piece may also be provided.

In the embodiment illustrated in figures 1a to 1e, the fixing strap 8 is a single strap that is wrapped entirely around the busbar stack 1. The fixing strap 8 is fixed to the fastener 20 of one of the anchor pieces 7 at one corner of the busbar stack 1 and wrapped around the three other corners of the busbar stack, and thus around the three other anchor pieces 7, the second end of the fixing strap being fastened to the same fastener 20 as the first end of the strap, as best seen in figure 1b. The fixing strap 8 thus holds the four anchor pieces 7 to the four corners of the busbar stack 1 and subsequently the two Rogowski cable supports 5 may be mounted against opposite side edges 18 of the busbar stack by sliding engagement between the fixing rail 9a of the cable support 5 and complementary rail 9b of the anchor piece, or by clipping the fixing rail 9a to the complementary rail 9b.

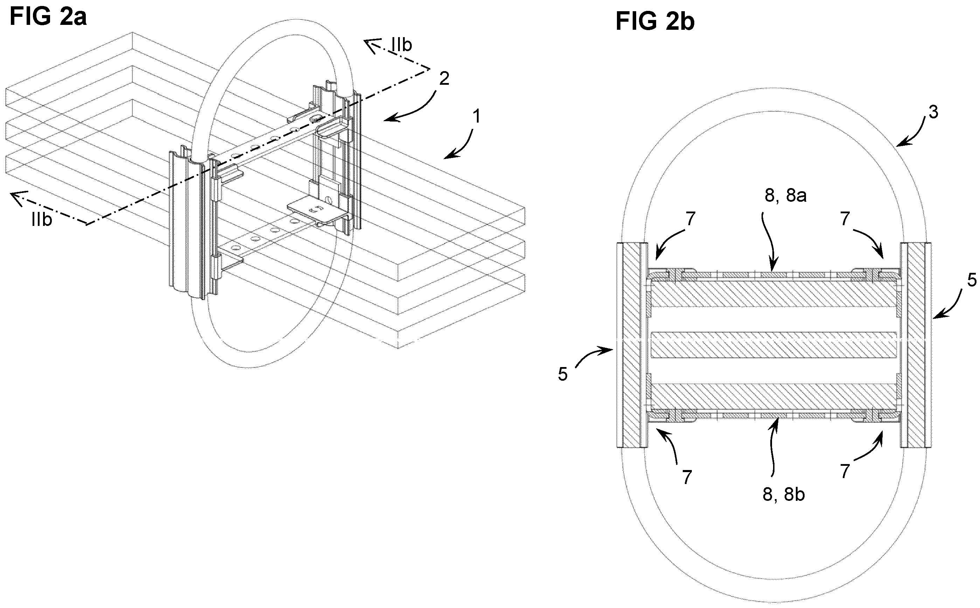

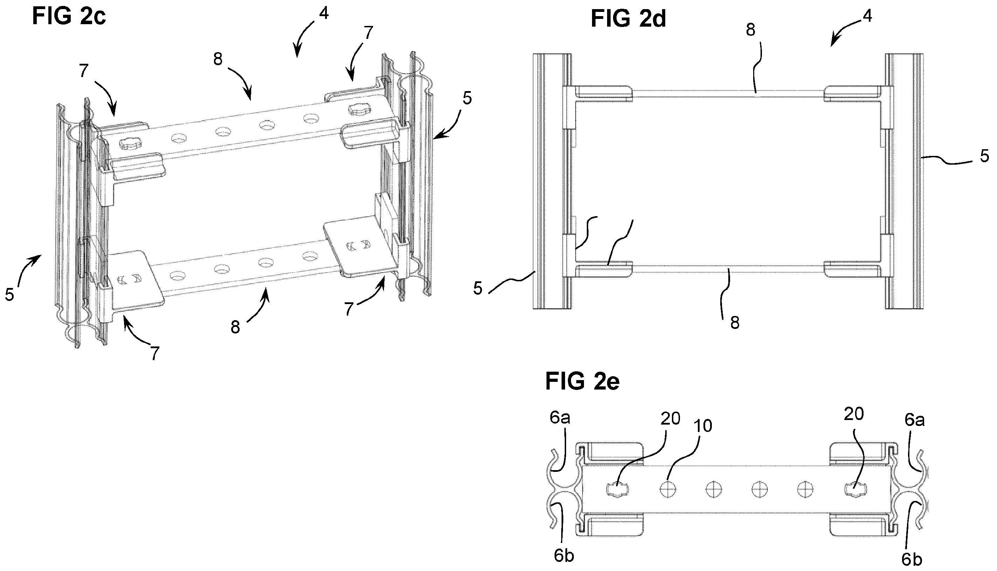

In the variant illustrated in figures 2a to 2e, a plurality of fixing straps 8a, 8b are provided, at least a first fixing strap 8a that extends between two anchor pieces 7 on a top side of the busbar stack and a second fixing strap 8b that extends between two anchor pieces 7 on a bottom side of the busbar stack 1. In this variant, the anchor pieces 7 may be fixed to the Rogowski cable supports 5 prior to assembly against the sides 18 of the busbar stack 1 and subsequently the fixing straps 8 may be coupled to the anchor pieces 7 on opposite side edges of the busbar stack arrangement. Various other assembly steps or orders of assembly may be envisaged. For instance, the fixing straps 8 may be pre-assembled to the anchor pieces 7 and one Rogowski cable support 5 on one side, and then the other ends fastened to the anchor pieces on the other side when they are mounted against the busbar stack arrangement. In yet another variant (not shown), there may be a single fixing strap however that is not wrapped completely around the busbar arrangement but that only is wrapped around three sides of the busbar stacked arrangement, the ends being fastened to anchor pieces on the top and bottom sides similar to the embodiments of figures 2a to 2e.

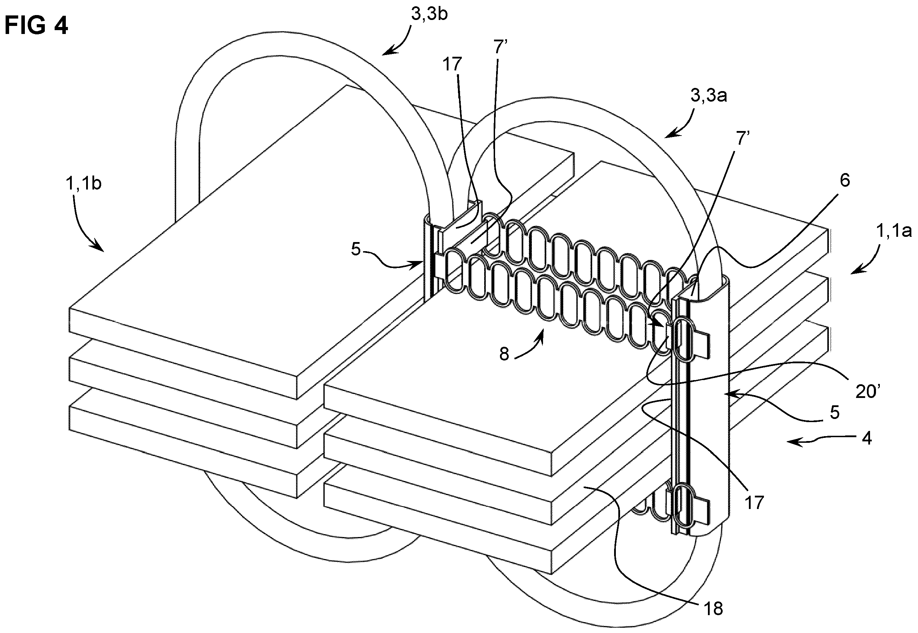

As illustrated in figure 4, in a variant, the fixing straps 8 may engage fasteners 20' on the anchor piece that are arranged on a wall section that is mounted against the base wall 17 of the Rogowski cable support 5, and the second wall portions that overlay the busbar may be included (not shown) or omitted as shown in figure 4.

The fixing straps 8 are preferably made of an elastic stretchable material such as a silicone polymer material, or may comprise rigid portions interconnected by an elastically stretchable section to allow the fixing straps to be in a stretched tensioned position when fastened to the anchor pieces so as to pull the opposed Rogowski cable supports 5 against the opposed outer edges 18 of the busbar stack 1.

In the embodiments of figures 1a to 3, the fixing straps are for instance in the form of an elastomeric band with a plurality of spaced apart holes that serve as the fasteners 10 that engage fixing studs 20 that serve as fasteners on the anchor pieces 7.

In the illustrated embodiments, the Rogowski cable support 5 may advantageously comprise a cable holder channel 6 configured to hold at least two Rogowski cables 3.

In a first embodiment, as illustrated in figures 1a to 3, the cable holder channel comprises a first cable holder channel 6a and a second cable holder channel 6b connected together by a center wall section 16, each of the first and second cable holder channels 6a, 6b comprising an open side with tapered entry edges 14 of a slightly smaller opening width than the cable channel formed therein, configured for clipping around the Rogowski cable 3. A Rogowski cable 3 can thus be press-fitted into each of the first and second cable holder channels 6a, 6b. The cable holder channel configured to hold two or at least two Rogowski cables allows to mount two different Rogowski cables 3a, 3b to a single Rogowski cable support 5, Thus in a multi-conductor arrangement, such as illustrated in figures 3 and 4, the Rogowski cable support 5 coupled to one of the busbar stacks 1a, 1c may be used for supporting a Rogowski cable 3 mounted around an adjacent busbar stack 1b.

Thus, for instance in the three-phase conductor system illustrated in figure 3, only two Rogowski cable holders 4a, 4b are required for mounting three Rogowski cables 3a, 3b, 3c, one around each of the three busbar stacks 1a, 1b, 1c.

The Rogowski cable support is preferably made of a linear prismatic part that allows the cable support to be cut to the required length corresponding to the height of the busbars stack arrangement and to easily mount the anchor pieces 7 and slide them such that the fixing straps 8 are arranged close to the top and bottom surfaces 21 of the busbar stack 1.

Advantageously, the simple adjustment of the height of the Rogowski cable support as well as the easy fixing of the anchor pieces and straps allow rapid and easily adjustable fixing of the Rogowski cable 3 around the corresponding busbar stack 1. Moreover, in embodiments with cable holder channels 6 that are configured to mount two Rogowski cables, a very compact multi-conductor arrangement with each busbar stack having a Rogowski cable therearound is provided.

### List of references used

**Busbar stack 1**
   Busbars
   Outer side edges 18
   Top, bottom sides 21
**Rogowski current transducer arrangement 2**
   **Rogowski cable 3**
      Rogowski section
      Connection section 11
      Electrical cable 12
   **Rogowski cable holder 4**
      **Rogowski cable support 5**
         **Cable holder channel 6**
         First cable holder channel 6a
         Second cable holder channel 6b
            Tapered entry edges 14
         Centre wall section 16
         Base wall 17
         Fixing rail 9a
      **Anchor piece 7**
         Complementary rail 9b
         Fastener 20
         Edge wall section
         Top/bottom wall overlay section 19
      **Fixing strap 8**
         Complementary Fastener 10
         Stud / hole
         Latch shoulder

## Claims

1. A Rogowski current transducer arrangement (2) for a busbar stack (1) comprising a one or more stacked busbar conductors, the busbar stack having opposed top and bottom major sides (21), each busbar extending between opposed minor side edges (18), the Rogowski current transducer arrangement comprising a Rogowski cable (3) and a Rogowski cable holder (4) configured to support and hold the Rogowski cable (3) around the busbar stack, the Rogowski cable holder (4) comprising a Rogowski cable support (5) having a base wall (17) and a cable holder channel (6), the base wall (17) mountable along said outer side edges (18) of the busbars of the busbar stack (1),
**characterised in that**
the Rogowski cable holder further comprises anchor pieces (7) mountable at corners of the busbar stack, and one or more fixing straps (8) having fasteners (10) for coupling to fasteners (20) on the anchor pieces, the base wall (17) of the Rogowski cable support (5) comprises fixing rails (9a) and the anchor piece (7) comprises complementary rails (9b) configured for coupling the Rogowski cable support to the anchor piece and fixing straps (8) for securing the Rogowski cable around the busbar stack.

2. The Rogowski current transducer arrangement according to the preceding claim wherein the cable holder channel (6) of the Rogowski cable support (5) is configured to hold at least two Rogowski cables.

3. The Rogowski current transducer arrangement according to the preceding claim wherein the cable holder channel (6) comprises a first cable holder channel (6a) and a second cable holder channel (6b) connected to a center wall section (16), each of the first and second cable holder channels (6a, 6b) comprising an opening with tapered entry edges (14) configured for insertion and clipping of a section of the Rogowski cable within the cable holder channel.

4. The Rogowski current transducer arrangement according to any preceding claim wherein the fixing strap (8) is made of an elastomeric material.

5. The Rogowski current transducer arrangement according to any preceding claim wherein the fixing strap (8) is in the form of a band with holes therein serving as the fasteners (10).

6. The Rogowski current transducer arrangement according to any preceding claim wherein the anchor pieces (7) each comprise an edge extension (9b) for engaging a side edge of the busbar stack and an overlay extension (19) orthogonal thereto for engaging a top or bottom surface of the busbar stack.

7. The Rogowski current transducer arrangement according to any preceding claim wherein the fastener (20) is in the form of a stud upstanding from the overlay extension.

8. The Rogowski current transducer arrangement according to any preceding claim wherein the fixing rail of the Rogowski cable support (5) and fixing rail of the anchor pieces (7) slidably engage each other to allow adjustment of the position of the anchor pieces (7) along the Rogowski cable support (5).

9. A Rogowski current transducer system for a multi-conductor system comprising at least three busbar stacks arranged in parallel side-by side, comprising at least two Rogowski current transducer arrangements according to any preceding claim and at least one additional Rogowski cable (3) coupled to adjacent Rogowski cable holders of the at least two Rogowski current transducer arrangements.

10. The Rogowski current transducer system according to the preceding claim for a three phase conductor system comprising three busbar stacks arranged in parallel side-by side, comprising two Rogowski current transducer arrangements and one additional Rogowski cable (3) arranged between the two Rogowski current transducer arrangements and coupled to adjacent Rogowski cable holders of the two Rogowski current transducer arrangements.

## Patentansprüche

1. Rogowski-Stromwandleranordnung (2) für einen Sammelschienenstapel (1), der einen oder mehrere gestapelte Sammelschienenleiter umfasst, wobei der Sammelschienenstapel eine obere und eine untere Hauptseite (21) aufweist, die einander entgegengesetzt sind, wobei jede Sammelschiene sich zwischen entgegengesetzten Kanten (18) von kleineren Seiten erstreckt, wobei die Rogowski-Stromwandleranordnung ein Rogowski-Kabel (3) und einen Rogowski-Kabelhalter (4) umfasst, der dazu ausgestaltet ist, das Rogowski-Kabel (3) um den Sammelschienenstapel herum zu stützen und zu halten, wobei der Rogowski-Kabelhalter (4) eine Rogowski-Kabelhalterung (5) umfasst, die eine Basiswand (17) und einen Kabelhalterkanal (6) umfasst, wobei die Basiswand (17) entlang der äußeren Seitenkanten (18) der Sammelschienen des Sammelschienenstapels (1) montierbar ist,
**dadurch gekennzeichnet, dass** der Rogowski-Kabelhalter ferner Ankerstücke (7), die an Ecken des Sammelschienenstapels montierbar sind, und einen oder mehrere Befestigungsgurte (8) umfasst, die Befestigungselemente (10) zum Koppeln an Befestigungselemente (20) an den Ankerstücken aufweisen, wobei die Basiswand (17) der Rogowski-Kabelhalterung (5) Befestigungsschienen (9a) umfasst und das Ankerstück (7) ergänzende Schienen (9b), die zum Koppeln der Rogowski-Kabelhalterung an das Ankerstück ausgestaltet sind, und Befestigungsgurte (8) zum Sichern des Rogowski-Kabels um den Sammelschienenstapel herum umfasst.

2. Rogowski-Stromwandleranordnung nach dem vorhergehenden Anspruch, wobei der Kabelhalterkanal (6) der Rogowski-Kabelhalterung (5) dazu ausgestaltet ist, mindestens zwei Rogowski-Kabel zu halten.

3. Rogowski-Stromwandleranordnung nach dem vorhergehenden Anspruch, wobei der Kabelhalterkanal (6) einen ersten Kabelhalterkanal (6a) und einen zweiten Kabelhalterkanal (6b) umfasst, die mit einem mittleren Wandabschnitt (16) verbunden sind, wobei jeder von dem ersten und dem zweiten Kabelhalterkanal (6a, 6b) eine Öffnung mit abgeschrägten Eintrittskanten (14) umfasst, die zum Einführen und Clippen eines Abschnitts des Rogowski-Kabels innerhalb des Kabelhalterkanals ausgestaltet sind.

4. Rogowski-Stromwandleranordnung nach einem der vorhergehenden Ansprüche, wobei der Befestigungsgurt (8) aus einem Elastomermaterial besteht.

5. Rogowski-Stromwandleranordnung nach einem der vorhergehenden Ansprüche, wobei der Befestigungsgurt (8) in der Form eines Bandes mit Löchern darin vorliegt, die als die Befestigungselemente (10) dienen.

6. Rogowski-Stromwandleranordnung nach einem der vorhergehenden Ansprüche, wobei die Ankerstücke (7) jeweils eine Kantenerverlängerung (9b) für den Eingriff einer Seitenkante des Sammelschienenstapels und eine Überlappungsverlängerung (19) orthogonal dazu für den Eingriff einer oberen oder unteren Oberfläche des Sammelschienenstapels umfassen.

7. Rogowski-Stromwandleranordnung nach einem der vorhergehenden Ansprüche, wobei das Befestigungselement (20) in der Form eines Bolzens vorliegt, der von der Überlappungsverlängerung hochsteht.

8. Rogowski-Stromwandleranordnung nach einem der vorhergehenden Ansprüche, wobei die Befestigungsschiene der Rogowski-Kabelhalterung (5) und die Befestigungsschiene der Ankerstücke (7) verschiebbar ineinandergreifen, um eine Anpassung der Position der Ankerstücke (7) entlang der Rogowski-Kabelhalterung (5) zu erlauben.

9. Rogowski-Stromwandlersystem für ein Mehrleitersystem, das mindestens drei Sammelschienenstapel umfasst, die parallel nebeneinander angeordnet sind, umfassend mindestens zwei Rogowski-Stromwandleranordnungen nach einem der vorhergehenden Ansprüche und mindestens ein zusätzliches Rogowski-Kabel (3), das an benachbarte Rogowski-Kabelhalter der mindestens zwei Rogowski-Stromwandleranordnungen gekoppelt ist.

10. Rogowski-Stromwandlersystem nach dem vorhergehenden Anspruch für ein Dreiphasenleitersystem, das drei Sammelschienenstapel umfasst, die parallel nebeneinander angeordnet sind, umfassend zwei Rogowski-Stromwandleranordnungen und ein zusätzliches Rogowski-Kabel (3), das zwischen den zwei Rogowski-Stromwandleranordnungen angeordnet ist und an benachbarte Rogowski-Kabelhalter der zwei Rogowski-Stromwandleranordnungen gekoppelt ist.

## Revendications

1. Agencement de transducteur de courant de Rogowski (2) pour un empilement de barres omnibus (1) comprenant un ou plusieurs conducteurs de barres omnibus empilées, l'empilement de barres omnibus ayant des côtés majeurs supérieur et inférieur (21), chaque barre omnibus s'étendant entre les bords latéraux mineurs (18), l'agencement de transducteur de courant de Rogowski comprenant un câble de Rogowski (3) et un porte-câble de Rogowski (4) configuré pour supporter et maintenir le câble de Rogowski (3) autour de l'empilement de barres omnibus, le porte-câble de Rogowski (4) comprenant un support de câble de Rogowski (5) ayant une paroi de base (17) et un canal de porte-câble (6), la paroi de base (17) pouvant être montée le long desdits bords latéraux externes (18) des barres omnibus de l'empilement de barres omnibus (1),
**caractérisé en ce que** :
le porte-câble de Rogowski comprend en outre des pièces d'ancrage (7) pouvant être montées aux coins de l'empilement de barres omnibus, et une ou plusieurs sangles de fixation (8) ayant des fixations (10) pour se coupler aux fixations (20) sur les pièces d'ancrage, la paroi de base (17) du support de câble de Rogowski (5) comprend des rails de fixation (9a) et la pièce d'ancrage (7) comprend des rails complémentaires (9b) configurés pour coupler le support de câble de Rogowski à la pièce d'ancrage et aux sangles de fixation (8) pour fixer le câble de Rogowski autour de l'empilement de barres omnibus.

2. Agencement de transducteur de courant de Rogowski selon la revendication précédente, dans lequel le canal de porte-câble de Rogowski (6) du support de câble de Rogowski (5) est configuré pour maintenir au moins deux câbles de Rogowski.

3. Agencement de transducteur de courant de Rogowski selon la revendication précédente, dans lequel le canal de porte-câble (6) comprend un premier canal de porte-câble (6a) et un second canal de porte-câble (6b) raccordé à une section de paroi centrale (16), chacun des premier et second canaux de porte-câble (6a, 6b) comprenant une ouverture avec des bords d'entrée progressivement rétrécis (14) configurés pour l'insertion et la coupure d'une section du câble de Rogowski dans le canal de porte-câble.

4. Agencement de transducteur de courant de Rogowski selon l'une quelconque des revendications précédentes, dans lequel la sangle de fixation (8) est réalisée avec un matériau élastomère.

5. Agencement de transducteur de courant de Rogowski selon l'une quelconque des revendications précédentes, dans lequel la sangle de fixation (8) se présente sous la forme d'une bande avec des trous dans cette dernière qui servent de fixations (10) .

6. Agencement de transducteur de courant de Rogowski selon l'une quelconque des revendications précédentes, dans lequel les pièces d'ancrage (7) comprennent chacune une extension de bord (9b) pour mettre en prise un bord latéral de l'empilement de barres omnibus et une extension superposée (19) orthogonale à cette dernière pour mettre en prise une surface supérieure ou inférieure de l'empilement de barres omnibus.

7. Agencement de transducteur de courant de Rogowski selon l'une quelconque des revendications précédentes, dans lequel la fixation (20) se présente sous la forme d'un goujon se dressant à partir de l'extension superposée.

8. Agencement de transducteur de courant de Rogowski selon l'une quelconque des revendications précédentes, dans lequel le rail de fixation du support de câble de Rogowski (5) et le rail de fixation des pièces d'ancrage (7) se mettent en prise de manière coulissante entre eux pour permettre le réglage de la position des pièces d'ancrage (7) le long du support de câble de Rogowski (5).

9. Système de transducteur de courant de Rogowski pour un système à plusieurs conducteurs comprenant au moins trois empilements de barres omnibus agencés en parallèle côte à côte, comprenant au moins deux agencements de transducteur de courant de Rogowski selon l'une quelconque des revendications précédentes et au moins un câble de Rogowski (3) supplémentaire couplé aux porte-câbles de Rogowski adjacents des au moins deux agencements de transducteur de courant de Rogowski.

10. Système de transducteur de courant de Rogowski selon la revendication précédente, pour un système de conducteur triphasé comprenant trois empilements de barres omnibus agencés en parallèle côte à côte, comprenant deux agencements de transducteur de courant de Rogowski et un câble de Rogowski (3) supplémentaire agencé entre les deux agencements de transducteur de courant de Rogowski et couplés aux porte-câbles de Rogowski adjacents des deux agencements de transducteur de courant de Rogowski.
